# EUROPEAN PATENT APPLICATION

(11) **EP 1 075 088 A2**
(43) Date of publication of application: **07.02.2001**
(21) Application number: 00306555.4
(22) Date of filing: 02.08.2000
(51) Int. Cl.: H03M 13/27, H03M 13/29, H03M 13/45

(54) **Encoding apparatus, encoding method, and providing medium**

(30) Priority: 02.08.1999 JP 21835099
(71) Applicant: SONY CORPORATION, Tokyo 141 (JP)
(72) Inventor: Murayama, Jun, c/o Intellectual Property Dept., Shinagawa-ku, Tokyo 141 (JP); Miyauchi, Toshiyuki, c/o Intellect. Property Dept., Shinagawa-ku, Tokyo 141 (JP); Hattori, Masayuki, c/o Intellectual Property Dept., Shinagawa-ku, Tokyo 141 (JP)
(74) Representative: Turner, James Arthur

(57) **Abstract**

A convolutional encoder for generating an outer code applies a convolutional operation to input data at an encoding rate of 2/3, and outputs an operation result to an interleaver. The interleaver interleaves the data input from the convolutional encoder and outputs to a convolutional encoder for generating an inner code. The convolutional encoder applies a convolutional operation to the data sent from the interleaver at an encoding rate of 1 (= 3/3), and outputs an operation result to a multi-level-modulation mapping circuit. The multi-level-modulation mapping circuit maps the data input from the convolutional encoder onto one transfer symbol of the 8PSK modulation method.

## Description

The present invention relates to encoding apparatuses and methods, and providing media.

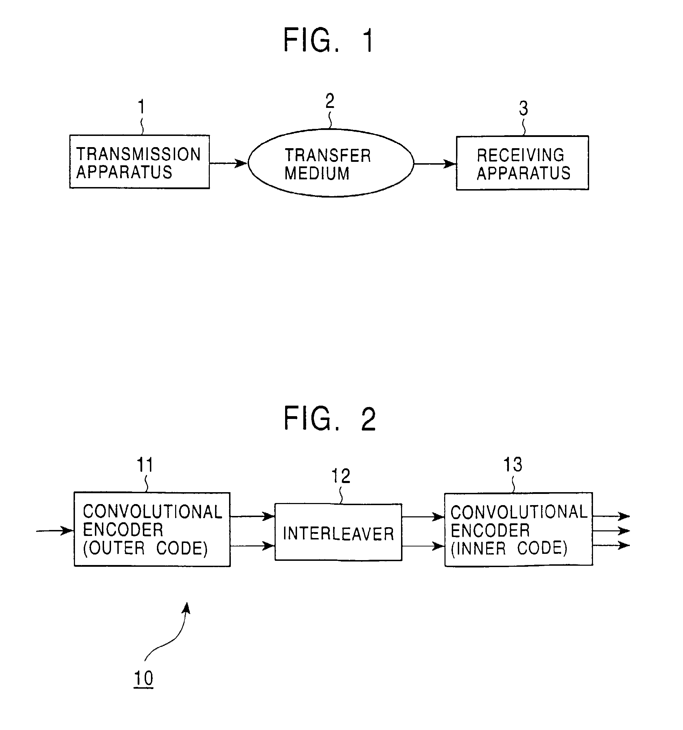

Fig. 1 shows the structure of a digital data transfer system. A transmission apparatus 1 applies a serial concatenated convolutional operation to input digital data at an encoding rate of 1/3, and outputs an operation result to a receiving apparatus 3 through a transfer medium 2. The receiving apparatus 3 receives the convolutionally encoded data transferred through the transfer medium 2, and decodes it.

Fig. 2 shows an example structure of an encoding apparatus 10 provided for the transmission apparatus 1, for executing a serial concatenated convolutional operation at an encoding rate of 1/3. An convolutional encoder 11 for generating an outer code applies a convolutional operation to input data at an encoding rate of 1/2 and outputs an operation result to an interleaver 12. In other words, each one bit of the input data is transformed into a two-bit code.

The interleaver 12 interleaves data input from the convolutional encoder 11 and outputs to a convolutional encoder 13.

The convolutional encoder 13 for generating an inner code applies a convolutional operation to data input from the interleaver 12 at an encoding rate of 2/3. In other words, each input two-bit data is transformed into a three-bit code. The operation result of the convolutional encoding operation executed in the convolutional encoder 13 is output to the receiving apparatus 3 through the transfer medium 2.

In other words, in the entire encoding apparatus 10, a serial concatenated convolutional operation is applied to input data at an encoding rate of 1/3 (= 1/2 x 2/3).

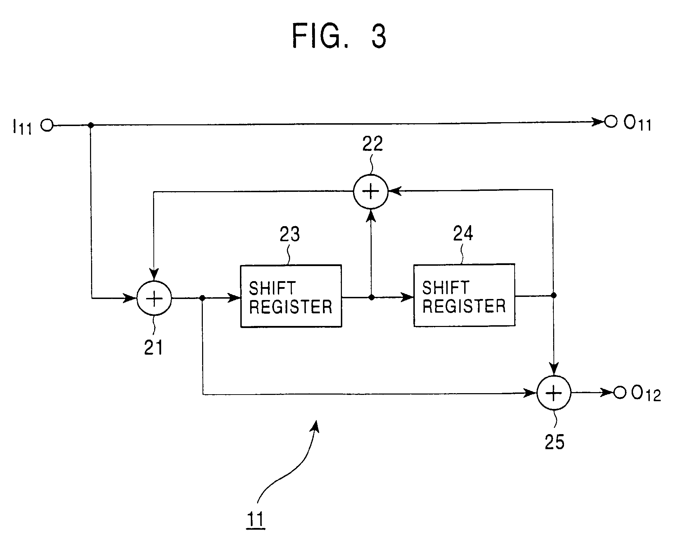

Fig. 3 shows an example structure of the convolutional encoder 11. Data input to an input terminal I11 is output to the interleaver 12 through an output terminal O11 as is, and is also input to an exclusive-OR circuit 21. The exclusive-OR circuit 21 applies an exclusive-OR operation to the data input from the input terminal I11 and data input from an exclusive-OR circuit 22, and outputs an operation result to a shift register 23 and to an exclusive-OR circuit 25.

The shift register 23 stores the data input from the exclusive-OR circuit 21, and outputs the stored data to the exclusive-OR circuit 22 and to a shift register 24, in synchronization with a clock.

The shift register 24 stores the data sent from the shift register 23, and outputs the stored data to the exclusive-OR circuit 22 and to the exclusive-OR circuit 25 in synchronization with the clock.

The exclusive-OR circuit 25 applies an exclusive-OR operation to the data sent from the exclusive-OR circuit 21 and the data sent from the shift register 24, and outputs an operation result to the interleaver 12 through an output terminal O12.

An operation of the convolutional encoder 11 will be described next. One-bit data input to the input terminal I11 is sequentially input to the exclusive-OR circuit 21 in synchronization with the clock. The exclusive-OR circuit 21 applies an exclusive-OR operation to the input one-bit data and one-bit data sent from the exclusive-OR circuit 22, and outputs a one-bit operation result to the shift register 23 and to the exclusive-OR circuit 25.

When the shift register 23 receives the one-bit data from the exclusive-OR circuit 21, the shift register 23 outputs (shifts) one-bit data currently stored, to the exclusive-OR circuit 22 and to the shift register 24, and stores instead the received one-bit data. When the shift register 24 receives the one-bit data sent from the shift register 23, the shift register 24 outputs one-bit data currently stored, to the exclusive-OR circuit 22 and to the exclusive-OR circuit 25, and stores instead the received one-bit data.

The exclusive-OR circuit 25 applies an exclusive-OR operation to the one-bit data sent from the exclusive-OR circuit 21 and the one-bit data sent from the shift register 24, and outputs a one-bit operation result to the interleaver 12 through the output terminal O12.

Convolutional encoding is executed in this way at an encoding rate of 1/2, and the input one-bit data is transformed into a two-bit code.

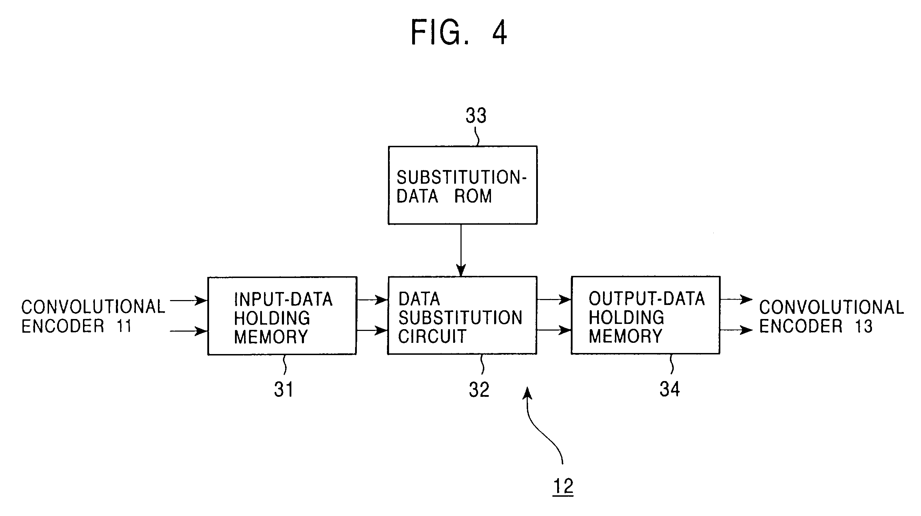

Fig. 4 shows an example structure of the interleaver 12. Data is input from the convolutional encoder 11 to an input-data holding memory 31. The input-data holding memory 31 stores the input data, and outputs the stored data to a data substitution circuit 32 at a predetermined timing. The data substitution circuit 32 interleaves the data input from the input-data holding memory 31 according to random-number information stored in a substitution-data ROM 33, and outputs to an output-data holding memory 34. The output-data holding memory 34 stores the data sent from the data substitution circuit 32, and outputs the stored data to the convolutional encoder 13 at a predetermined timing.

An operation of the interleaver 12 will be described next. Two-bit data is sequentially input from the convolutional encoder 11 to the input-data holding memory 31. The input-data holding memory 31 stores the two-bit input data in units of bits, and outputs the stored data to the data substitution circuit 32 at a predetermined timing (such as a timing when N-bit (N = 1, 2, ...) respective data is stored and two bit strings each formed of N bits are generated). The data substitution circuit 32 changes (interleaves) the order of each bit (of a total of N by 2 bits) of the two bit strings input from the input-data holding memory 31 according to the random-number information stored in the substitution-data ROM 33, and outputs to the output-data holding memory 34. The output-data holding memory 34 stores one-bit respective data sent from the data substitution circuit 32, and outputs the stored data to the convolutional encoder 13 at a predetermined timing.

The data sent from the convolutional encoder 11 is interleaved in this way.

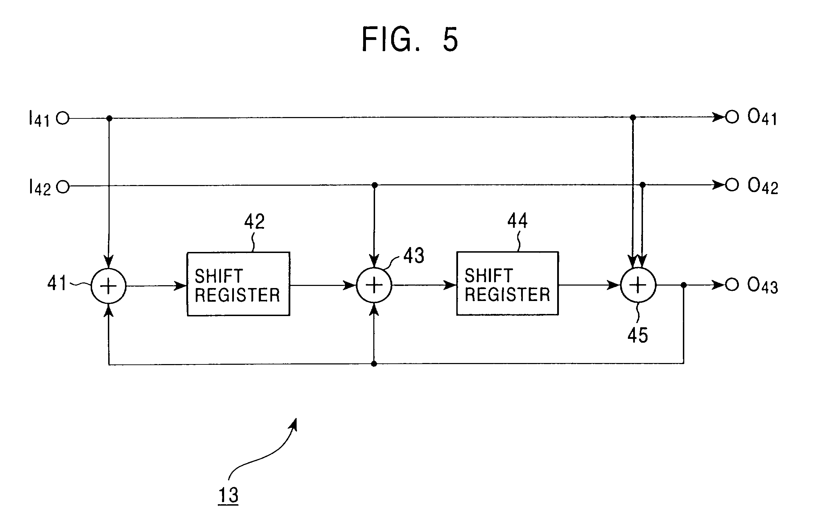

Fig. 5 shows an example structure of the convolutional encoder 13. Data input from the interleaver 12 to an input terminal I41 is output from an output terminal O41 as is and is also input to exclusive-OR circuits 41 and 45.

Another data input from the interleaver 12 to an input terminal I42 is output from an output terminal O42 as is and is also input to an exclusive-OR circuit 43 and to the exclusive-OR circuit 45.

The exclusive-OR circuit 41 applies an exclusive-OR operation to the data input from the input terminal I41 and to data input from the exclusive-OR circuit 45, and outputs an operation result to a shift register 42.

The shift register 42 stores the data sent from the exclusive-OR circuit 41 and outputs the stored data to the exclusive-OR circuit 43 in synchronization with the clock. The exclusive-OR circuit 43 applies an exclusive-OR operation to the data sent from the shift register 43, the input terminal I42, and the exclusive-OR circuit 45, and outputs an operation result to a shift register 44.

The shift register 44 stores the data sent from the exclusive-OR circuit 43, and outputs the stored data to the exclusive-OR circuit 45 in synchronization with the clock.

The exclusive-OR circuit 45 applies an exclusive-OR operation to the data sent from the shift register 44, the input terminal I41, and the input terminal I42, and outputs an operation result from an output terminal O43.

The data output from the output terminals O41 to O43 is transferred to the receiving apparatus 3 through the transfer medium 2.

The exclusive-OR circuits 41, 43, and 45 of the convolutional encoder 13 basically operate in the same way as the exclusive-OR circuits 21, 22, and 25 of the convolutional encoder 11, and the shift registers 42 and 44 of the convolutional encoder 13 basically operate in the same way as the shift registers 23 and 24 of the convolutional encoder 11. Therefore, a detailed description of an operation of the convolutional encoder 13 will be omitted. In the convolutional encoder 13, convolutional encoding is executed at an encoding rate of 2/3, and two-bit input data is transformed into a three-bit code.

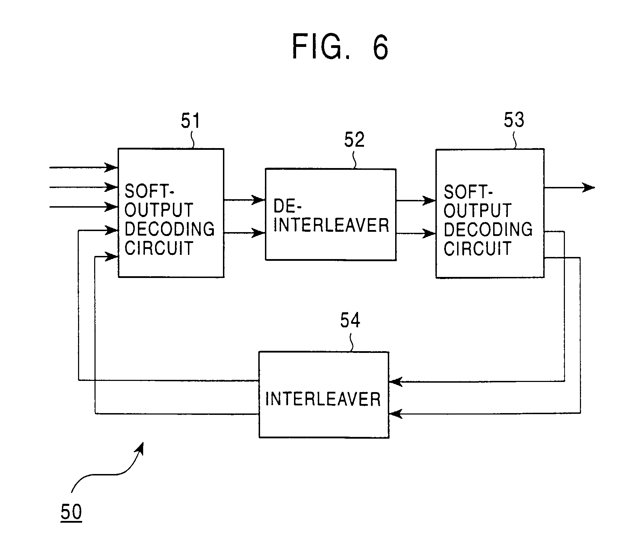

Fig. 6 shows an example structure of a decoding apparatus 50 provided for the receiving apparatus 3, for decoding data encoded by the encoding apparatus 10 shown in Fig. 2. Data transmitted from the encoding apparatus 10 and received by the receiving apparatus 3 is input to a soft-output decoding circuit 51 for decoding an inner code. The data includes noise generated on the transfer medium 2 and is an analog soft input. The soft-output decoding circuit 51 also receives data (soft input) sent from an interleaver 54.

The soft-output decoding circuit 51 calculates a probability that a soft input transmitted from the encoding apparatus 10 or a soft input sent from the interleaver 54 is 1 or 0, and outputs a calculation result (soft output) to a de-interleaver 52.

The soft output sent from the soft-output decoding circuit 51 to the de-interleaver 52 corresponds to the data interleaved by the interleaver 12 in the encoding apparatus 10. The de-interleaver 52 de-interleaves the data sent from the soft-output decoding circuit 51 such that the data interleaved by the interleaver 12 of the encoding apparatus 10 is changed back to the original state (a state in which each bit of the data is arranged in the order used immediately before interleaving).

A soft-output decoding circuit 53 for decoding an outer code calculates a probability that the data sent from the de-interleaver 52 is 1 or 0, and outputs a calculation result (soft output) to the interleaver 54. The soft-output decoding circuit 53 determines whether the data sent from the de-interleaver 52 is 1 or 0 according to the calculation result, and outputs a determination result (1 or 0).

The interleaver 54 interleaves the soft output sent from the soft-output decoding circuit 53 so as to be in the state obtained before it has been de-interleaved by the de-interleaver 52, and outputs to the soft-output decoding circuit 51.

An operation of the decoding apparatus 50 will be described next. Data output from the convolutional encoder 13 of the encoding apparatus 10 is input to the soft-output decoding circuit 51. In other words, the three soft inputs corresponding to three-bit data are sequentially input. When the soft-output decoding circuit 51 receives the three soft inputs, it calculates the probability that each input is 1 or 0, and outputs calculation results (soft outputs) to the de-interleaver 52.

The de-interleaver 52 de-interleaves the soft outputs sent from the soft-output decoding circuit 51 so as to have the order obtained before the data has been interleaved by the interleaver 12 of the encoding apparatus 10, in other words, so as to have the bit arrangement obtained when the data has been encoded by the convolutional encoder 11.

The soft-output decoding circuit 53 calculates a probability that each of the soft outputs sent from the de-interleaver 52 is 1 or 0, and counts the number of times the probability is obtained. The soft-output decoding circuit 53 determines whether the counted number of times the probability is obtained reaches a predetermined number. When it is determined that the counted number has not reached the predetermined number, the soft-output decoding circuit 53 outputs (returns) calculation results to the interleaver 54.

The interleaver 54 applies interleaving to the data sent from the soft-output decoding circuit 53, and outputs (returns) to the soft-output decoding circuit 51.

When the soft-output decoding circuit 51 receives soft inputs from the interleaver 54, the soft-output decoding circuit 51 again calculates a probability that each of the input soft inputs is 1 or 0, and outputs to the de-interleaver 52. The de-interleaver 52 applies deinterleaving to the input data, and outputs to the soft-output decoding circuit 53. In other words, until the soft-output decoding circuit 53 determines that the counted number reaches the predetermined number, the processes from the soft-output decoding circuit 51 to the interleaver 54 are repeatedly executed.

When the soft-output decoding circuit 53 determines that the counted number reaches the predetermined number, a soft decision is made according to the calculation results (probability that each data is 1 or 0), and outputs a determination result. More specifically, the soft-output decoding circuit 53 outputs "1" when the probability that the data is 1 is high (the probability that the data is 0 is low), and outputs "0" when the probability that the data is 0 is high (the probability that the data is 1 is low).

As described above, data input to the decoding apparatus 50 is decoded. Details of serial concatenated encoding are described in "Serial Concatenation of Interleaved Codes: Performance Analysis, Design, and Iterative Decoding," S. Benedetto, G. Montorsi, D. Divsalar, F. Pollara, TDA Progress Report 42-126, Jet Propulsion Laboratory, Pasadena, California, Aug. 15, 1996.

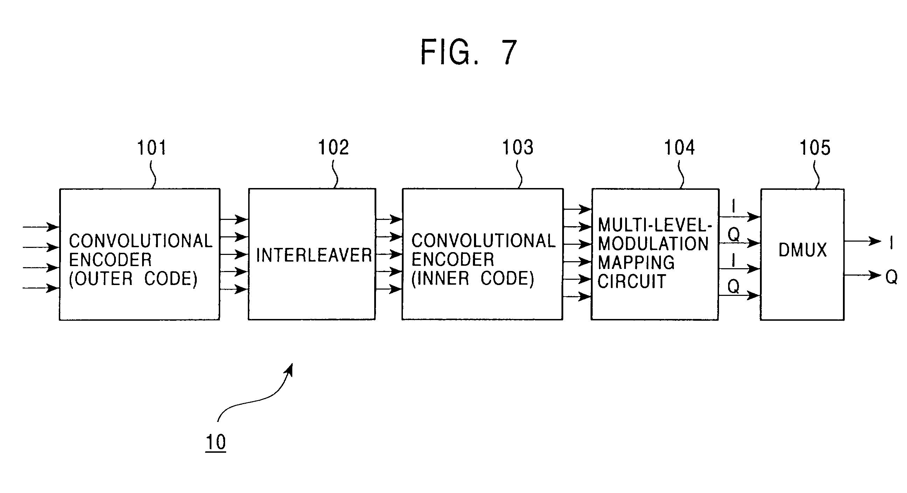

Fig. 7 shows another example structure of the encoding apparatus 10. The encoding apparatus 10 executes encoding (SCTCM (Serial Concatenated Trellis Coded Modulation) obtained by combining the above-described serial concatenated convolutional encoding and multi-level modulation. Details of the SCTCM method are described in "Serial and Hybrid Concatenation Codes with applications," D. Divsalar, F. Pollara, in Proc., Int. Symp. on Turbo Codes and Related to pics, Brest, France, pp. 80-87, Sept, 1997.

A convolutional encoder 101 for generating an outer code applies a convolutional operation to input data at an encoding rate of 4/5, and outputs an operation result to an interleaver 102. In other words, four-bit input data is transformed into a five-bit code.

The interleaver 102 interleaves the data sent from the convolutional encoder 101 and outputs to a convolutional encoder 103.

The convolutional encoder 103 for generating an inner code applies a convolutional operation to the data sent from the interleaver 102 at an encoding rate of 5/6, and outputs an operation result to a multi-level-modulation mapping circuit 104. In other words, five-bit input data is transformed into six-bit data.

The multi-level-modulation mapping circuit 104 maps the data input from the convolutional encoder 103 onto transfer symbols of the 8PSK modulation method in synchronization with the clock. Since one transfer-symbol signal point has three-bit data in the 8PSK modulation method, each set of three bits of six-bit data input from the convolutional encoder 103 is mapped onto one transfer symbol. In other words, two transfer symbols are generated in this case.

A de-multiplexer 105 de-multiplexes two transfer symbols sent from the multi-level-modulation mapping circuit 104, outputs each of the transfer symbols through the transfer medium in synchronization with a clock having half the period of the clock used when the transfer symbols have been generated.

In other words, in this case, serial concatenated convolutional encoding is executed at an encoding rate of 2/3 (= 4/6 = 4/5 x 5/6) in the entire encoding apparatus 10, and four-bit input data is transformed into a six-bit code.

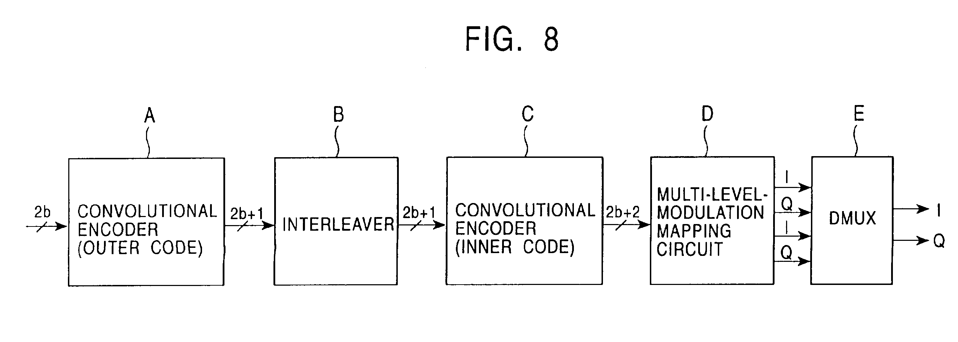

When encoding is achieved by a combination of serial concatenated encoding and multi-level modulation, an encoding rate of b (= 1, 2, ...)/(b + 1) is finally required, in general. Therefore, in an encoding apparatus (hereinafter called an SCTCM encoding apparatus) for achieving encoding by a combination of serial concatenated convolutional encoding and multi-level modulation, such as the encoding apparatus 10 shown in Fig. 7, an encoding rate for an outer code is set to 2b/(2b + 1) and an encoding rate for an inner code is set to (2b + 1)/(2b + 2), as shown in Fig. 8, to make the encoding rate of the apparatus to b/(b + 1). A code is mapped onto two transfer symbols.

A convolutional encoder A for generating an inner code transforms 2b-bit input data into a (2b + 1)-bit code. A convolutional encoder C for generating an outer code transforms (2b + 1)-bit data sent from the convolutional encoder A and interleaved by an interleaver B, into a (2b + 2)-bit code.

A multi-level-modulation mapping circuit D maps the (2b + 2)-bit data input from the convolutional encoder C onto transfer symbols in units of (b + 1) bits. In other words, two transfer symbols are generated.

In the encoding apparatus 10 shown in Fig. 7, for example, "b" is 2 and the convolutional encoder 101 transforms four-bit (two-by-two bit) input data into a five-bit (two-by-two-plus-1 bit) code.

The convolutional encoder 103 transforms 5-bit (two-by-two-plus-one bit) data sent from the convolutional encoder 101 and interleaved by the interleaver 102, into six-bit (two-by-two-plus-two bit) data.

The multi-level-modulation mapping circuit 104 maps the six-bit (two-by-two-plus-two bit) data input from the convolutional encoder 103 onto transfer symbols used in the 8PSK modulation method in units of three (two-plus-one) bits. Two transfer symbols of the 8PSK modulation method are generated.

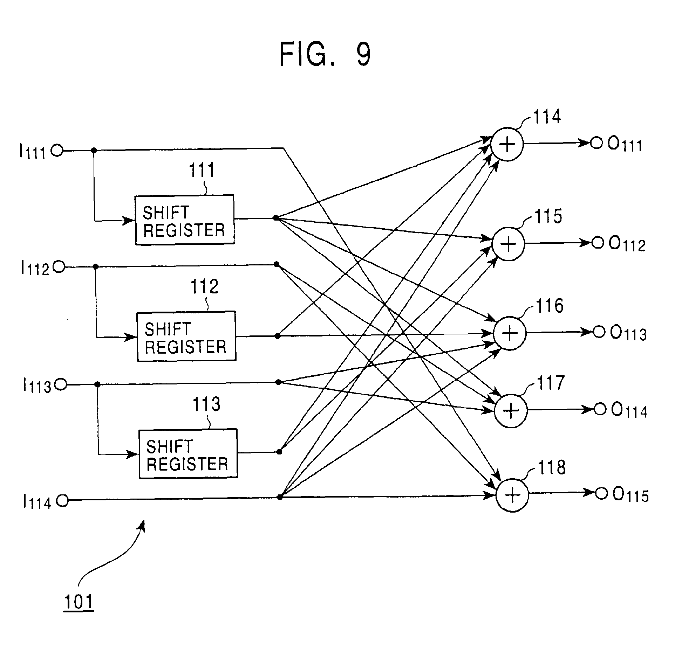

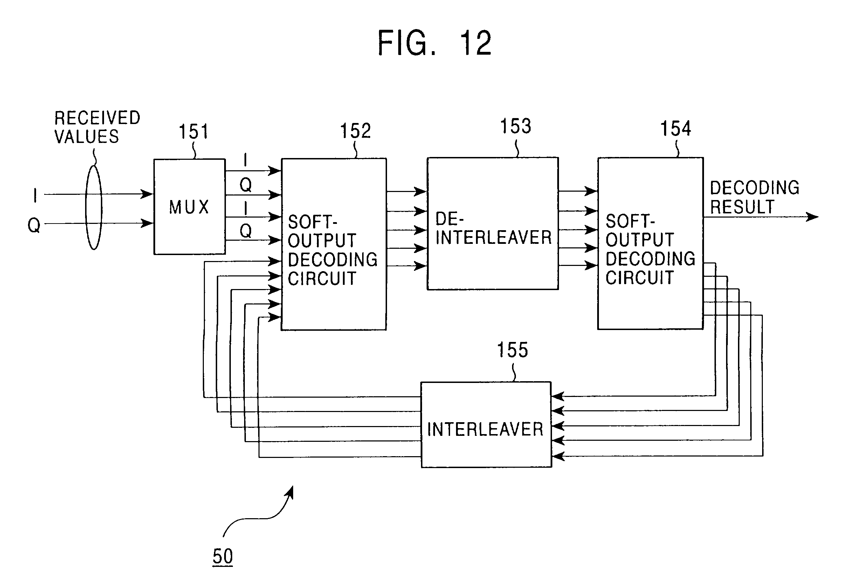

In an SCTCM encoding apparatus, an encoding rate for the outer code is set to 2b/(2b + 1) and an encoding rate for the inner code is set to (2b + 1)/(2b + 2) to obtain a whole encoding rate of b/(b + 1), and two transfer symbols are generated. As a result, as shown in Fig. 9 to Fig. 11, the number of bits processed by each section (in this case, the convolutional encoder 101 to the de-multiplexer 105) of the SCTCM encoding apparatus (in this case, the encoding apparatus 10) becomes large, and therefore, the structure of each section becomes complicated. The structure of a decoding apparatus also becomes complicated, as shown in Fig. 12.

Fig. 9 shows an example structure of the convolutional encoder 101. Data input from an input terminal I111 is input to a shift register 111 and to an exclusive-OR circuit 118. Data input from an input terminal I112 is input to a shift register 112 and to exclusive-OR circuits 117 and 118.

Data input from an input terminal I113 is input to a shift register 113 and exclusive-OR circuits 116 and 117. Data input from an input terminal I114 is input to exclusive-OR circuits 114, 115, 116, and 118.

The shift register 111 stores input data, and outputs the stored data to the exclusive-OR circuits 114, 115, 116, and 117 in synchronization with a clock.

The shift register 112 stores input data, and outputs the stored data to the exclusive-OR circuits 114 and 116 in synchronization with the clock. The shift register 113 stores input data, and outputs the stored data to the exclusive-OR circuits 114 and 115 in synchronization with the clock.

The exclusive-OR circuit 114 applies an exclusive-OR calculation to the data input from the shift registers 111, 112, and 113 and the input terminal I114, and outputs a calculation result to the interleaver 102 through an output terminal O111. The exclusive-OR circuit 115 applies an exclusive-OR calculation to the data input from the shift registers 111 and 113 and the input terminal I114, and outputs a calculation result to the interleaver 102 through an output terminal O112.

The exclusive-OR circuit 116 applies an exclusive-OR calculation to the data input from the shift registers 111 and 112 and the input terminals I113 and I114, and outputs a calculation result to the interleaver 102 through an output terminal O113. The exclusive-OR circuit 117 applies an exclusive-OR calculation to the data input from the shift register 111 and the input terminals I112 and I113, and outputs a calculation result to the interleaver 102 through an output terminal O114. The exclusive-OR circuit 118 applies an exclusive-OR calculation to the data input from the input terminals I111, I112, and I114, and outputs a calculation result to the interleaver 102 through an output terminal O115.

The exclusive-OR circuits 114 to 118 of the convolutional encoder 101 basically operate in the same way as the exclusive-OR circuits 21, 22, and 25 of the convolutional encoder 11, and the shift registers 111 to 113 of the convolutional encoder 101 basically operate in the same way as the shift registers 23 and 24 of the convolutional encoder 11. Therefore, a detailed description of an operation of the convolutional encoder 101 will be omitted. In the convolutional encoder 101, convolutional encoding is executed at an encoding rate of 4/5, and four-bit input data is transformed into a five-bit code.

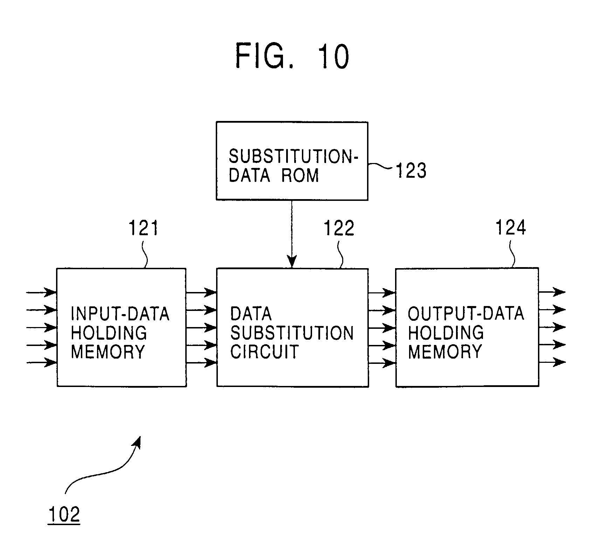

Fig. 10 shows an example structure of the interleaver 102. Data output from the convolutional encoder 101 is input to an input-data holding memory 121. The input-data holding memory 121 stores the input data, and outputs the stored data to a data substitution circuit 122 at a predetermined timing. The data substitution circuit 122 interleaves the data input from the input-data holding memory 121 according to random-number information stored in a substitution-data ROM 123, and outputs to an output-data holding memory 124. The output-data holding memory 124 stores the data sent from the data substitution circuit 122, and outputs the stored data to the convolutional encoder 103 at a predetermined timing.

Since the input-data holding memory 121 to the output-data holding memory 124 in the interleaver 102 basically operate in the same way as the corresponding input-data holding memory 31 to the corresponding output-data holding memory 34 of the interleaver 12, a detailed description of an operation of the interleaver 102 will be omitted. In the interleaver 102, interleaving is executed, and data input from the convolutional encoder 101 is interleaved.

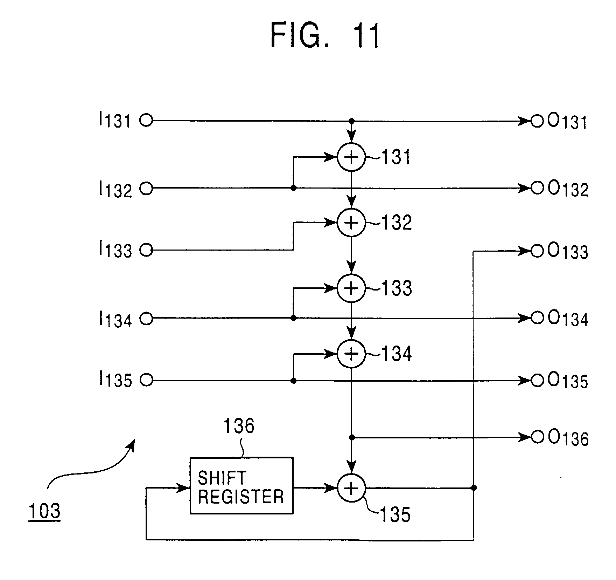

Fig. 11 shows an example structure of the convolutional encoder 103. Data input from an input terminal I131 is output from an output terminal O131 as is and is also input to an exclusive-OR circuit 131. Data input from an input terminal I132 is output from an output terminal O132 as is and is also input to an exclusive-OR circuit 131.

Data input from an input terminal I133 is input to an exclusive-OR circuit 132. Data input from an input terminal I134 is output from an output terminal O134 as is and is also input to an exclusive-OR circuit 133. Data input from an input terminal I135 is output from an output terminal O135 as is and is also input to an exclusive-OR circuit 134.

The exclusive-OR circuit 131 applies an exclusive-OR calculation to the data input from the input terminals I131 and I132, and outputs a calculation result to the exclusive-OR circuit 132.

The exclusive-OR circuit 132 applies an exclusive-OR calculation to the data input from the input terminal I133 and the exclusive-OR circuit 131, and outputs a calculation result to the exclusive-OR circuit 133.

The exclusive-OR circuit 133 applies an exclusive-OR calculation to the data input from the input terminal I134 and the exclusive-OR circuit 132, and outputs a calculation result to the exclusive-OR circuit 134. The exclusive-OR circuit 134 applies an exclusive-OR calculation to the data input from the input terminal I135 and the exclusive-OR circuit 133, and outputs a calculation result to an exclusive-OR circuit 135 and to an output terminal O136.

The exclusive-OR circuit 135 applies an exclusive-OR calculation to the data sent from the exclusive-OR circuit 134 and to data sent from a shift register 136, and outputs a calculation result to the shift register 136 and to an output terminal O133.

The shift register 136 stores the data sent from the exclusive-OR circuit 135 and outputs the stored data to the exclusive-OR circuit 135 in synchronization with the clock.

The exclusive-OR circuits 131 to 135 of the convolutional encoder 103 basically operate in the same way as the exclusive-OR circuits 21, 22, and 25 of the convolutional encoder 11, and the shift register 136 of the convolutional encoder 103 basically operates in the same way as the shift registers 23 and 24 of the convolutional encoder 11. Therefore, a detailed description of an operation of the convolutional encoder 103 will be omitted. In the convolutional encoder 103, convolutional encoding is executed at an encoding rate of 5/6, and five-bit input data is transformed into a six-bit code.

Fig. 12 shows another example structure of the decoding apparatus 50. The decoding apparatus decodes data encoded by the encoding apparatus 10 shown in Fig. 7. A multiplexer 151 receives transfer symbols transmitted from the encoding apparatus 10 shown in Fig. 7 and received by the receiving apparatus 3. The multiplexer 151 collectively outputs the corresponding two transfer symbols among input transfer symbols to an soft-output decoding circuit 152. Since the soft-output decoding circuit 152 to an interleaver 155 basically have the same functions as the soft-output decoding circuit 51 to the interleaver 54 of the decoding circuit 50 shown in Fig. 6, descriptions thereof will be omitted.

As described above, the structure of the decoding apparatus 50 becomes complicated.

Various respective aspects and features of the invention are defined in the appended claims.

The present invention has been made in consideration of the above situations. Accordingly, embodiments of the present invention can make the structures of an encoding apparatus and a decoding apparatus simple while a sufficient encoding rate is obtained.

The invention provides an encoding apparatus including first transform means for transforming b-bit input data into a (b + 1)-bit outer code; interleaving means for interleaving the outer code, which has been transformed into by the first transform means; second transform means for transforming the (b + 1)-bit outer code which has been transformed into by the first transform means and interleaved by the interleaving means, into an inner code having the number of bits equal to (b + 1) or less; and mapping means for mapping the inner code, which has been transformed into by the second transform means, on one transfer symbol of a predetermined modulation method.

The encoding apparatus may be configured such that a predetermined bit is fixed to zero among the b-bit data input to the first transform means, and a predetermined bit is fixed to zero among the (b + 1)-bit outer code interleaved by the interleaving means, input to the second transform means.

The encoding apparatus may be configured such that a predetermined bit is fixed to zero among the (b + 1)-bit outer code which has been transformed into by the first transform means, and a predetermined bit is fixed to zero among the inner code having the number of bits equal to (b + 1) or less, which has been transformed into by the second transform means.

The invention also provides an encoding method including a first transform step of transforming b-bit input data into a (b + 1)-bit outer code; an interleaving step of interleaving the outer code, which has been transformed into in the first transform step; a second transform step of transforming the (b + 1)-bit outer code which has been transformed into in the first transform step and interleaved in the interleaving step, into an inner code having the number of bits equal to (b + 1) or less; and a mapping step of mapping the inner code, which has been transformed into in the second transform step, on one transfer symbol of a predetermined modulation method.

The invention also provides a providing medium for providing a computer-controllable program, the program including a first transform step of transforming b-bit input data into a (b + 1)-bit outer code; an interleaving step of interleaving the outer code, which has been transformed into in the first transform step; a second transform step of transforming the (b + 1)-bit outer code which has been transformed into in the first transform step and interleaved in the interleaving step, into an inner code having the number of bits equal to (b + 1) or less; and a mapping step of mapping the inner code, which has been transformed into in the second transform step, on one transfer symbol of a predetermined modulation method.

The providing medium may be a recording medium into which the program has been recorded.

In the encoding apparatus described above, the encoding method described above, and a providing medium described above, b-bit input data is transformed into a (b + 1)-bit outer code; the outer code, which has been transformed into, is interleaved; the (b + 1)-bit outer code which has been transformed into and interleaved is transformed into an inner code having the number of bits equal to (b + 1) or less; and the inner code, which has been transformed into, is mapped on one transfer symbol of a predetermined modulation method. Therefore, the structure of a decoding apparatus can be made simple.

The invention also provides an encoding apparatus including serial concatenated encoding means which has at least two convolutional encoding sections, including a convolutional encoding section disposed at the top and a convolutional encoding section disposed at the last, and at least one interleaving section disposed between convolutional encoding sections, and in which input data is sequentially input to the convolutional encoding section disposed at the top, to each interleaving section, and then to each convolutional encoding section; and multi-level modulation means for multi-level-modulating the output of the serial concatenated encoding means, wherein the encoding rate of at least one convolutional encoding section is 1 or more.

The encoding apparatus may be configured such that the convolutional encoding section disposed at the top executes convolutional encoding at an encoding rate of less than 1.

In the encoding apparatus, at least two convolutional encoding sections, including a convolutional encoding section disposed at the top and a convolutional encoding section disposed at the last, and at least one interleaving section disposed between convolutional encoding sections are provided, input data is sequentially input to the convolutional encoding section disposed at the top, to each interleaving section, and then to each convolutional encoding section, the output of the serial concatenated encoding means is multi-level modulated, and the encoding rate of at least one convolutional encoding section is 1 or more. Therefore, the structure of a decoding apparatus can be made simple.

The invention also provides an encoding method including a first convolutional-encoding step of convolutional-encoding an input signal at a first encoding rate and of outputting a first convolutional-encoded signal; and a signal processing step of applying signal processing to the input signal natural-number M times, wherein each signal processing of the signal processing applied natural-number M times includes an interleaving step of applying interleaving to an input signal; and a second convolutional-encoding step of convolutional-encoding the processing result obtained in the interleaving step, at a second encoding rate and of outputting a second convolutional-encoded signal; among the signal processing applied natural-number M times, an input signal input in first signal processing is the first convolutional-encoded signal and input signals input in second and subsequent signal processing are the second convolutional-encoded signal; and at least one of the first encoding rate and the second encoding rate is 1 or more.

The encoding method may be configured such that the second encoding rate differs in the signal processing executed natural-number M times.

The encoding method may be configured such that the first encoding rate is 1 or more.

The invention also provides a providing medium for providing a computer-controllable program, the program including a first convolutional-encoding step of convolutional-encoding an input signal at a first encoding rate and of outputting a first convolutional-encoded signal; and a signal processing step of applying signal processing to the input signal natural-number M times, wherein each signal processing of the signal processing applied natural-number M times includes an interleaving step of applying interleaving to an input signal; and a second convolutional-encoding step of convolutional-encoding the processing result obtained in the interleaving step, at a second encoding rate and of outputting a second convolutional-encoded signal; among the signal processing executed natural-number M times, an input signal input in first signal processing is the first convolutional-encoded signal and input signals input in second and subsequent signal processing are the second convolutional-encoded signal; and at least one of the first encoding rate and the second encoding rate is 1 or more.

The providing medium may be a recording medium in which the program has been stored.

In the encoding method described above and the providing medium described above, an input signal is convolutionally encoded at a first encoding rate and output as a first convolutional-encoded signal, signal processing is applied to the input signal natural-number M times; in each signal processing of the signal processing executed natural-number M times, an input signal is interleaved, and convolutional-encoding is applied to the result of interleaving at a second encoding rate and output as a second convolutional-encoded signal; among the signal processing executed natural-number M times, an input signal input in a first signal processing is the first convolutional-encoded signal and input signals input in second and subsequent signal processing are the second convolutional-encoded signal, and at least one of the first encoding rate and the second encoding rate is 1 or more. Therefore, the structure of a decoding apparatus can be made simple.

The invention will now be described by way of example with reference to the accompanying drawings, throughout which like parts are referred to by like references, and in which:

Fig. 1 is a view of a digital-data transfer system.

Fig. 2 is a block diagram showing an example structure of an encoding apparatus 10.

Fig. 3 is a block diagram showing an example structure of a convolutional encoder 11 shown in Fig. 2.

Fig. 4 is a block diagram showing an example structure of an interleaver 12 shown in Fig. 2.

Fig. 5 is a block diagram showing an example structure of a convolutional encoder 13 shown in Fig. 2.

Fig. 6 is a block diagram showing an example structure of a decoding apparatus 50.

Fig. 7 is a block diagram showing another example structure of the encoding apparatus 10.

Fig. 8 is a view showing the encoding rate of an encoding apparatus which uses serial concatenated encoding and multi-level modulation.

Fig. 9 is a block diagram showing an example structure of a convolutional encoder 101 shown in Fig. 7.

Fig. 10 is a block diagram showing an example structure of an interleaver 102 shown in Fig. 7.

Fig. 11 is a block diagram showing an example structure of a convolutional encoder 103 shown in Fig. 7.

Fig. 12 is a block diagram showing another example structure of the decoding apparatus 50.

Fig. 13 is a block diagram showing an example structure of an encoding apparatus 200 according to a first embodiment of the present invention.

Fig. 14 is a block diagram showing an example structure of a convolutional encoder 201 shown in Fig. 13.

Fig. 15 is a block diagram showing an example structure of an interleaver 202 shown in Fig. 13.

Fig. 16 is a block diagram showing an example structure of a convolutional encoder 203 shown in Fig. 13.

Fig. 17 is a block diagram showing an example structure of a decoding apparatus 250 according to the present invention.

Fig. 18 is a block diagram showing an example structure of the encoding apparatus 200, according to a second embodiment.

Fig. 19 is a block diagram showing an example structure of a convolutional encoder 301 shown in Fig. 18.

Fig. 20 is a block diagram showing another example structure of the convolutional encoder 301 shown in Fig. 18.

Fig. 21 is a block diagram showing another example structure of a convolutional encoder 203 shown in Fig. 18.

Fig. 22 is a trellis diagram of the convolutional encoder 301 shown in Fig. 20.

Fig. 23 is a trellis diagram of the convolutional encoder 301 shown in Fig. 19.

Fig. 24 is a block diagram showing another example structure of the convolutional encoder 203 shown in Fig. 18.

Fig. 25 is a block diagram showing an example structure of a personal computer 501.

Fig. 26 is a flowchart showing an operation of a CPU 511 in the personal computer 501.

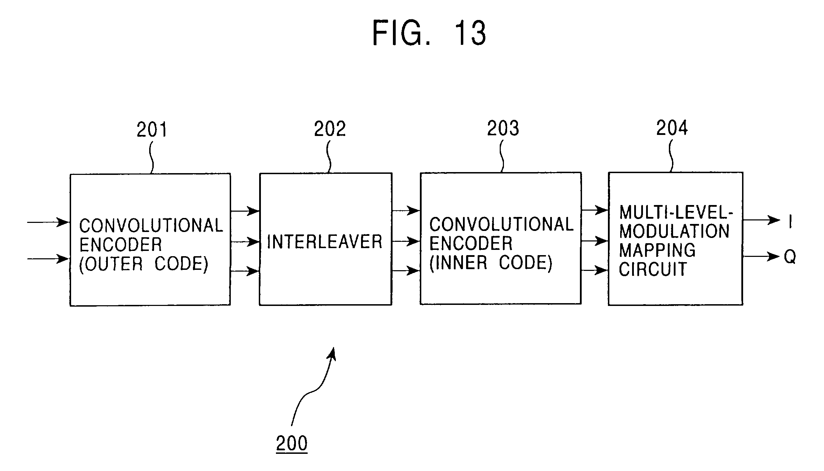

Fig. 13 shows an example structure of an encoding apparatus 200 according to a first embodiment of the present invention. A convolutional encoder 201 for generating an outer code applies a convolutional operation to input data at an encoding rate of 2/3, and outputs an operation result to an interleaver 202. In other words, two-bit input data is transformed into a three-bit code.

The interleaver 202 interleaves the data input from the convolutional encoder 201 and outputs to a convolutional encoder 203.

The convolutional encoder 203 for generating an inner code applies a convolutional operation to the data sent from the interleaver 202 at an encoding rate of 1 (= 3/3), and outputs an operation result to a multi-level-modulation mapping circuit 204. In other words, three-bit input data is transformed into a three-bit code.

The multi-level-modulation mapping circuit 204 maps the data input from the convolutional encoder 203 onto transfer symbols in the 8PSK modulation method in synchronization with the clock. Since three-bit data is input from the convolutional encoder 203 in this case, the multi-level-modulation mapping circuit 204 maps the three-bit data onto one transfer-symbol signal point. In other words, one transfer symbol is generated.

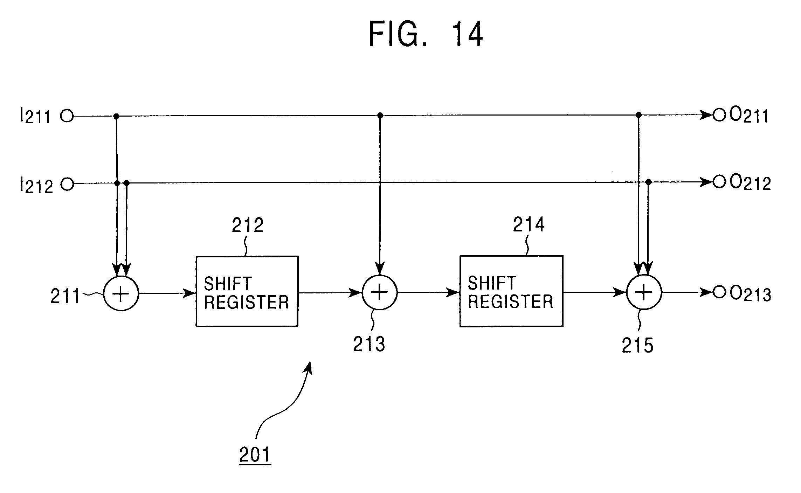

Fig. 14 shows an example structure of the convolutional encoder 201. Data input from an input terminal I211 is output from an output terminal O211 as is to the interleaver 202, and is also input to exclusive-OR circuits 211, 213, and 215. Data input from an input terminal I212 is output from an output terminal O212 as is to the interleaver 202, and is also input to the exclusive-OR circuits 211 and 215.

The exclusive-OR circuit 211 applies an exclusive-OR operation to the data input from the input terminals I211 and I212, and outputs an operation result to a shift register 212.

The shift register 212 stores the data sent from the exclusive-OR circuit 211 and outputs the stored data to the exclusive-OR circuit 213 in synchronization with the clock. The exclusive-OR circuit 213 applies an exclusive-OR operation to the data sent from the shift register 212 and the input terminal I211, and outputs an operation result to a shift register 214.

The shift register 214 stores the data sent from the exclusive-OR circuit 213, and outputs the stored data to the exclusive-OR circuit 215 in synchronization with the clock.

The exclusive-OR circuit 215 applies an exclusive-OR operation to the data sent from the shift register 214, the input terminal I211, and the input terminal I212, and outputs an operation result to the interleaver 202 through an output terminal O213.

The exclusive-OR circuits 211, 213, and 215 of the convolutional encoder 201 basically operate in the same way as the exclusive-OR circuits 21, 22, and 25 of the convolutional encoder 11, and the shift registers 212 and 214 of the convolutional encoder 201 basically operate in the same way as the shift registers 23 and 24 of the convolutional encoder 11. Therefore, a detailed description of an operation of the convolutional encoder 201 will be omitted. In the convolutional encoder 201, convolutional encoding is executed at an encoding rate of 2/3, and two-bit input data is transformed into a three-bit code.

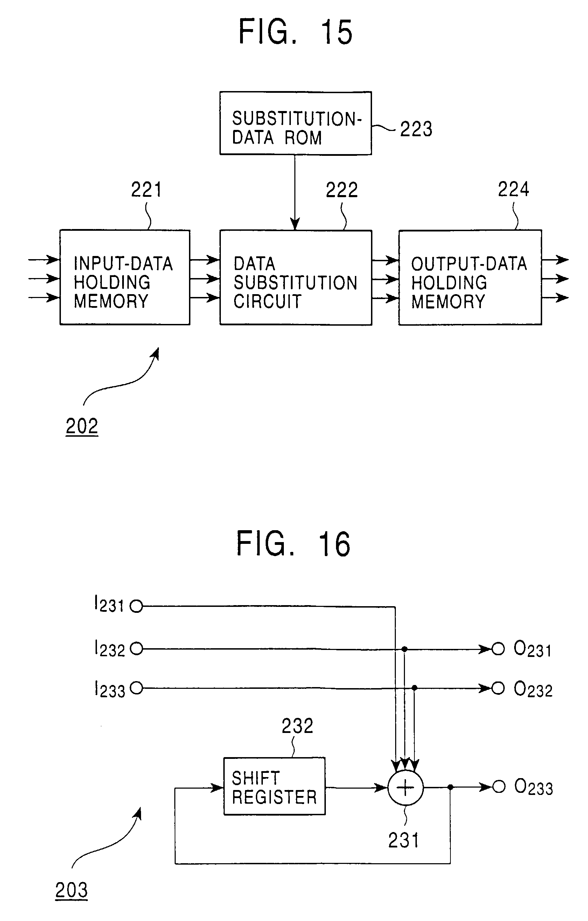

Fig. 15 shows an example structure of the interleaver 202. Data output from the convolutional encoder 201 is input to an input-data holding memory 221. The input-data holding memory 221 stores the input data, and outputs the stored data to a data substitution circuit 222 at a predetermined timing. The data substitution circuit 222 interleaves the data input from the input-data holding memory 221 according to random-number information stored in a substitution-data ROM 223, and outputs to an output-data holding memory 224. The output-data holding memory 224 stores the data sent from the data substitution circuit 222, and outputs the stored data to the convolutional encoder 203 at a predetermined timing.

Since the input-data holding memory 221 to the output-data holding memory 224 in the interleaver 202 basically operate in the same way as the corresponding input-data holding memory 31 to the corresponding output-data holding memory 34 of the interleaver 12, a detailed description of an operation of the interleaver 202 will be omitted. In the interleaver 202, interleaving is executed, and data input from the convolutional encoder 201 is interleaved.

Fig. 16 shows an example structure of the convolutional encoder 203. Data input from an input terminal I231 is input to an exclusive-OR circuit 231. Data input from an input terminal I232 is output from an output terminal O232 as is, and is also input to an exclusive-OR circuit 231.

The exclusive-OR circuit 231 applies an exclusive-OR calculation to the data input from the input terminals I231, I232, and I233, and outputs a calculation result through an output terminal O233, and to a shift register 232. The shift register 232 stores the data sent from the exclusive-OR circuit 231 and outputs the stored data to the exclusive-OR circuit 231 in synchronization with the clock.

The data output from the output terminals O231 to O233 is transferred to the receiving apparatus 3 through the transfer medium 2.

The exclusive-OR circuit 231 of the convolutional encoder 203 basically operates in the same way as the exclusive-OR circuits 21, 22, and 25 of the convolutional encoder 11, and the shift register 232 of the convolutional encoder 203 basically operates in the same way as the shift registers 23 and 24 of the convolutional encoder 11. Therefore, a detailed description of an operation of the convolutional encoder 203 will be omitted. In the convolutional encoder 203, convolutional encoding is executed at an encoding rate of 1 (= 3/3), and three-bit input data is transformed into a three-bit code.

As described above, since the convolutional encoder 203 for generating an inner code executes convolutional encoding at an encoding rate of 1 (= 3/3) to apply a convolutional-encoding calculation to data input to the encoding apparatus 200 at an encoding rate of 2/3 (= (2/3) x (3/3)), namely, at an encoding rate of b/(b + 1), a code output from the convolutional encoder 203 is mapped on one transfer symbol.

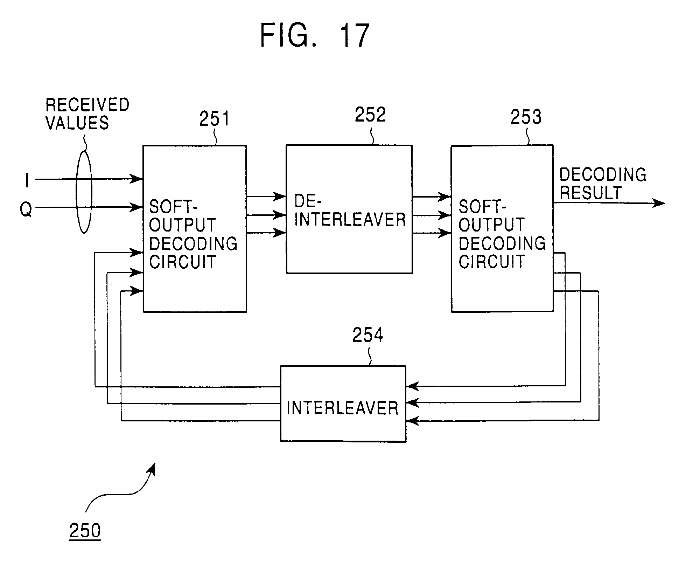

Fig. 17 shows an example structure of a decoding apparatus 250 for decoding data encoded by the encoding apparatus 200. Since a soft-output decoding circuit 251 to an interleaver 254 basically have the same structures as the soft-output decoding circuit 51 to the interleaver 54 of the decoding circuit 50 shown in Fig. 6, detailed descriptions thereof will be omitted. One transfer symbol is input to the decoding apparatus 250 and the symbol is decoded.

Since only one transfer symbol is input and decoding is applied to the symbol, as described above, the decoding apparatus 250 has a simpler structure than the decoding apparatus 50 shown in Fig. 12.

Fig. 17 shows an example structure of the decoding apparatus 250 for decoding data encoded by the encoding apparatus 200. Data (a transfer-symbol signal point on which three-bit data is mapped, output from the multi-level-modulation mapping circuit 204 of the encoding apparatus 200) transmitted from the encoding apparatus 200 is input to a soft-output decoding circuit 251 for decoding an inner code. The data includes noise generated during transfer and is an analog soft input. The soft-output decoding circuit 251 also receives data (soft input) sent from an interleaver 254.

The soft-output decoding circuit 251 calculates a probability that the soft input transmitted from the encoding apparatus 200 or the soft input sent from the interleaver 254 is 1 or 0, and outputs a calculation result (soft output) to a de-interleaver 252.

The soft output sent from the soft-output decoding circuit 251 to the de-interleaver 252 corresponds to the data interleaved by the interleaver 202 in the encoding apparatus 200. The de-interleaver 252 de-interleaves the data sent from the soft-output decoding circuit 251 such that the data interleaved by the interleaver 202 of the encoding apparatus 200 is changed back to the original state (a state in which each bit of the data is arranged in the order used immediately before interleaving).

A soft-output decoding circuit 253 for decoding an outer code calculates a probability that the data sent from the de-interleaver 252 is 1 or 0, and outputs a calculation result (soft output) to the interleaver 254. The soft-output decoding circuit 253 determines whether the data sent from the de-interleaver 252 is 1 or 0 according to the calculation result, and outputs a determination result (1 or 0).

The interleaver 254 interleaves the soft output sent from the soft-output decoding circuit 253 so as to be in the state obtained before it has been de-interleaved by the de-interleaver 252, and outputs to the soft-output decoding circuit 251.

An operation of the decoding apparatus 250 will be described next. Data (a transfer-symbol signal point on which three-bit data is mapped) output from the multi-level-modulation mapping circuit 204 of the encoding apparatus 200 is input to the soft-output decoding circuit 251. In other words, the three soft inputs corresponding to three-bit data are sequentially input. When the soft-output decoding circuit 251 receives the three soft inputs, it calculates the probability that each input is 1 or 0, and outputs calculation results (soft outputs) to the de-interleaver 252.

The de-interleaver 252 de-interleaves the soft outputs sent from the soft-output decoding circuit 251 so as to have the order obtained before the data has been interleaved by the interleaver 202 of the encoding apparatus 200, in other words, so as to have the bit arrangement obtained when the data has been encoded by the convolutional encoder 201.

The soft-output decoding circuit 253 calculates a probability that each of the soft outputs sent from the de-interleaver 52 is 1 or 0, and counts the number of times the probability is obtained. The soft-output decoding circuit 253 determines whether the counted number of times the probability is obtained reaches a predetermined number. When it is determined that the counted number has not reached the predetermined number, the soft-output decoding circuit 253 outputs (returns) the calculation results to the interleaver 254.

The interleaver 254 applies interleaving to the data sent from the soft-output decoding circuit 253, and outputs (returns) to the soft-output decoding circuit 251.

When the soft-output decoding circuit 251 receives soft inputs from the interleaver 254, the soft-output decoding circuit 251 again calculates a probability that each of the input soft inputs is 1 or 0, and outputs to the de-interleaver 252. The de-interleaver 252 applies deinterleaving to the input data, and outputs to the soft-output decoding circuit 253. In other words, until the soft-output decoding circuit 253 determines that the counted number reaches the predetermined number, the processes from the soft-output decoding circuit 251 to the interleaver 254 are repeatedly executed.

When the soft-output decoding circuit 253 determines that the counted number reaches the predetermined number, a soft decision is made according to the calculation results (probability that the data is 1 or 0), and outputs a determination result. More specifically, the soft-output decoding circuit 253 outputs "1" when the probability that the data is 1 is high (the probability that the data is 0 is low), and outputs "0" when the probability that the data is 0 is high (the probability that the data is 1 is low).

As described above, data input to the decoding apparatus 250 is decoded. Since only one transfer symbol is input and decoding is applied to the symbol, in this way, the decoding apparatus 250 has a simpler structure than the decoding apparatus 50 shown in Fig. 12.

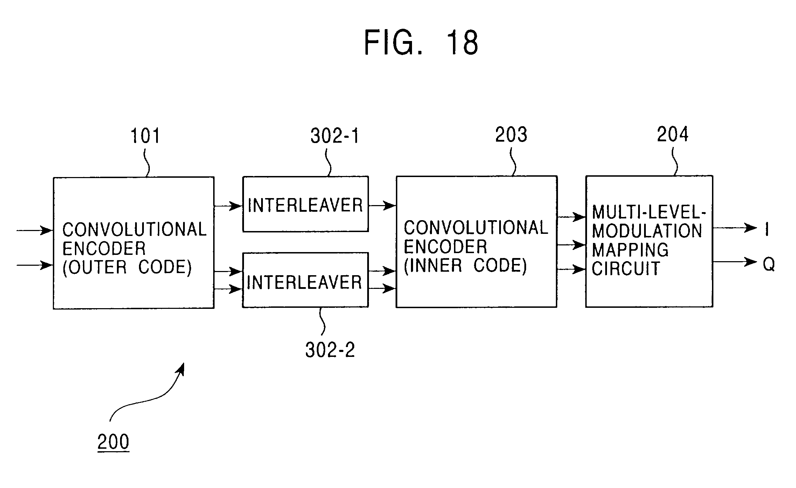

Fig. 18 shows an example structure of the encoding apparatus 200, according to a second embodiment. In the encoding apparatus, a convolutional encoder 301 is provided instead of the convolutional encoder 201 of the encoding apparatus 200 shown in Fig. 13, and two interleavers 302-1 and 302-2 are provided in stead of the interleaver 202.

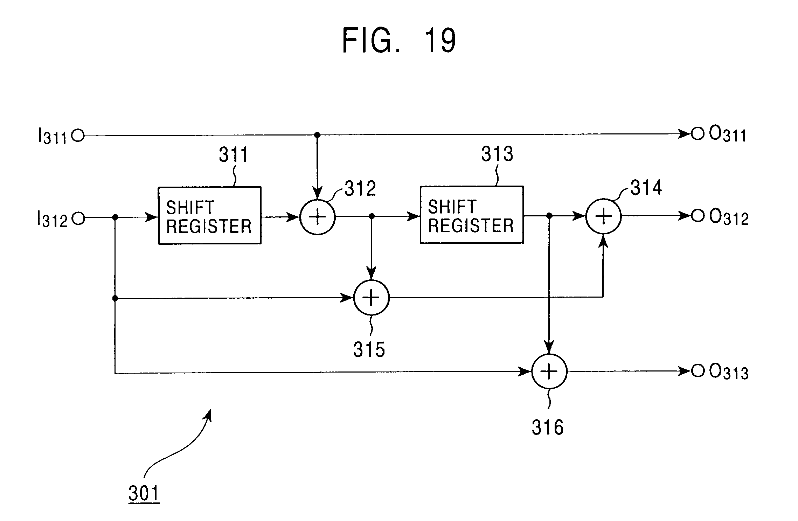

Fig. 19 shows an example structure of the convolutional encoder 301. Data input from an input terminal I311 is output through an output terminal O311 as is to the interleaver 302-1, and is also input to an exclusive-OR circuit 312. Data input from an input terminal I312 is input to a shift register 311 and to exclusive-OR circuits 315 and 316.

The shift register 311 stores the data input from the input terminal I312 and outputs the stored data to the exclusive-OR circuit 312 in synchronization with the clock. The exclusive-OR circuit 312 applies an exclusive-OR operation to the data sent from the input terminal I311 and the shift register 311, and outputs an operation result to a shift register 313 and to the exclusive-OR circuit 315.

The shift register 313 stores the data sent from the exclusive-OR circuit 312, and outputs the stored data to an exclusive-OR circuit 314 and to the exclusive-OR circuit 316 in synchronization with the clock. The exclusive-OR circuit 314 applies an exclusive-OR operation to the data sent from the shift register 313 and the exclusive-OR circuit 315, and outputs an operation result through an output terminal O312 to the interleaver 302-2.

The exclusive-OR circuit 315 applies an exclusive-OR operation to the data sent from the input terminal I312 and the exclusive-OR circuit 312, and outputs an operation result to the exclusive-OR circuit 314. The exclusive-OR circuit 316 applies an exclusive-OR operation to the data sent from the input terminal I312 and the shift register 313, and outputs an operation result through an output terminal O313 to the interleaver 302-2.

The interleaver 301-1 interleaves the data sent from the output terminal O311 of the convolutional encoder 301, and outputs to the convolutional encoder 203. The interleaver 301-2 interleaves the data sent from the output terminals O312 and O313 of the convolutional encoder 301, and outputs to the convolutional encoder 203.

Also in the encoding apparatus 200 of the second embodiment, a serial concatenated convolutional operation is applied to input data at an encoding rate of 2/3 and an operation result is mapped on one transfer symbol of the 8PSK modulation method, in the same way as in the first embodiment.

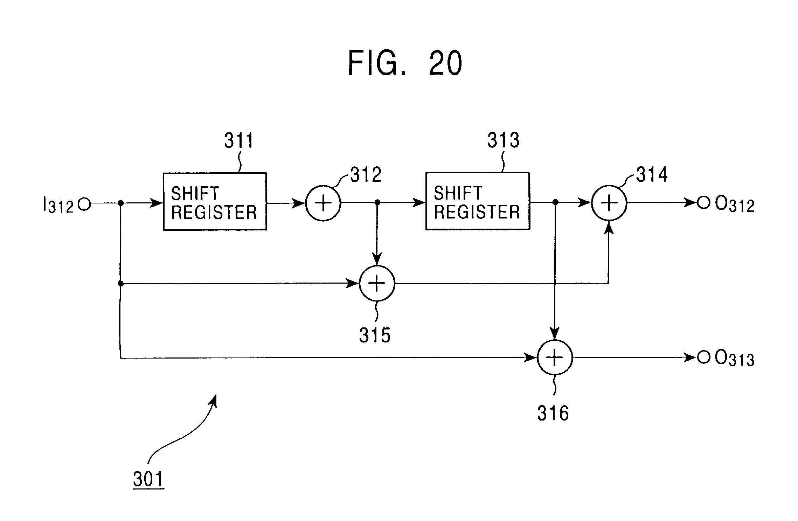

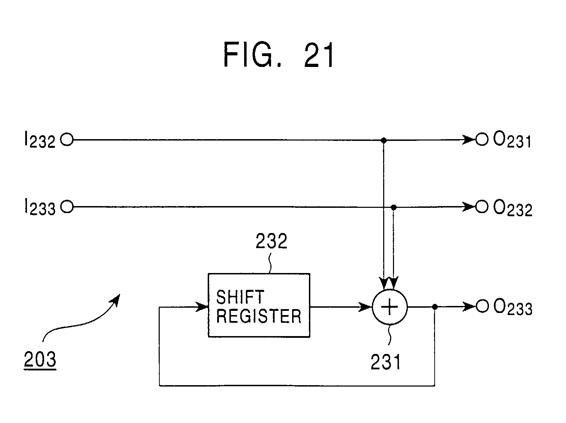

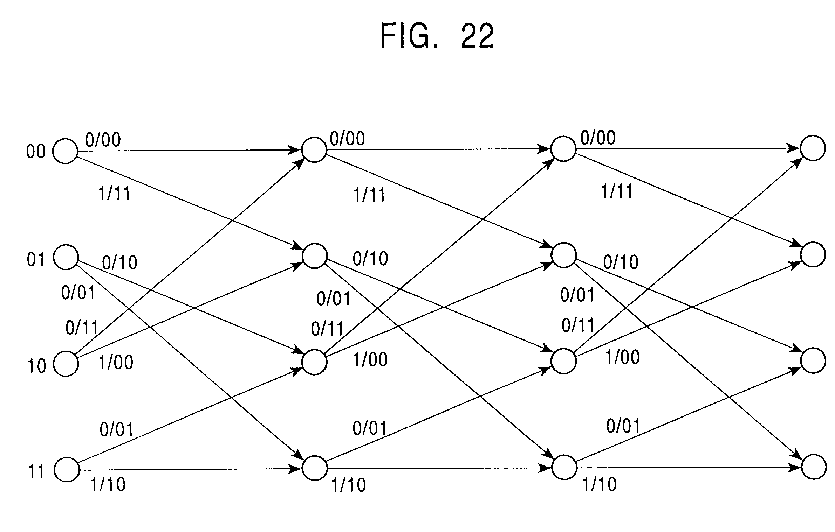

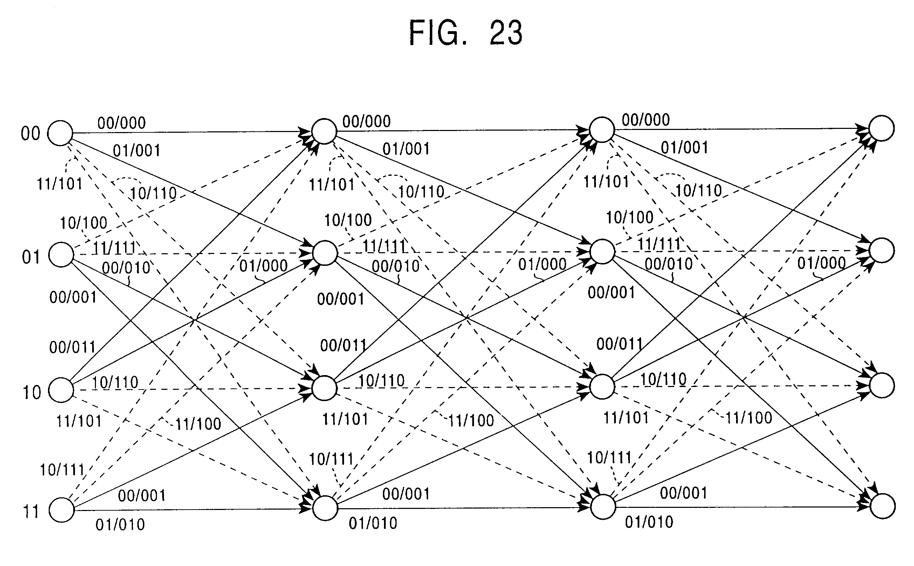

When, in the encoding apparatus 200 of the second embodiment, data input from one of the input terminals I311 and I312 of the convolutional encoder 301, for example, from the input terminal I311, is fixed to zero to substantially make the structure of the convolutional encoder 301 to that shown in Fig. 20 so that the encoding rate becomes 1/2; and data input from the input terminal I231 of the convolutional encoder 203 (shown in Fig. 16) is fixed to zero to substantially make the structure of the convolutional encoder 203 to that shown in Fig. 21 so that the encoding rate becomes 2/3, encoding is achieved at the same encoding rate (= 1/3) as that performed in the encoding apparatus 10 shown in Fig. 2. The trellis diagram of the convolutional encoder 301 shown in Fig. 20 is indicated in Fig. 22, which is a part of the trellis diagram (solid lines in Fig. 23 indicate the trellis diagram shown in Fig. 22) shown in Fig. 23 of the convolutional encoder 301 shown in Fig. 19. In the same way, the trellis diagram of the convolutional encoder 203 shown in Fig. 21 is also a part of the trellis diagram of the convolutional encoder 203 shown in Fig. 16. In other words, even if the encoding rate of the encoding apparatus 200 shown in Fig. 18 is changed from 2/3 to 1/3, or from 1/3 to 2/3, and encoding is achieved, data can be decoded by one set of decoding apparatus.

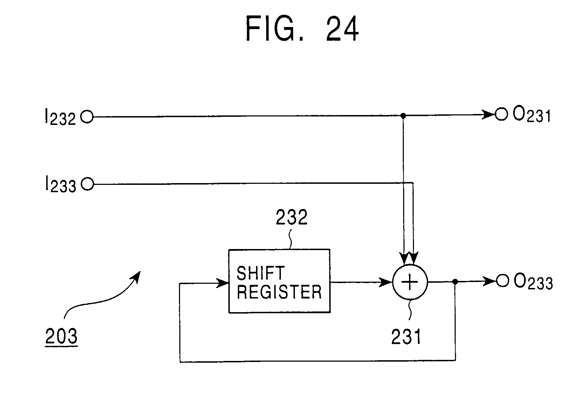

In addition, data output from the output terminal O232 of the convolutional encoder 203 shown in Fig. 21 can be fixed (punctured) to zero to substantially make the structure of the convolutional encoder 203 to that shown in Fig. 24 so that the encoding rate becomes 1 (= 2/2). In this case, the trellis diagram of the convolutional encoder 203 is a part of the trellis diagram of the convolutional encoder 203 shown in Fig. 21. Therefore, data encoded by the encoding apparatus 200 shown in Fig. 18 which uses the convolutional encoder 301 shown in Fig. 20 and the convolutional encoder 203 shown in Fig. 24 is decoded by a decoding apparatus for decoding data encoded by the encoding apparatus 10 shown in Fig. 2.

As described above, in the encoding apparatus 200 shown in Fig. 18, even when the encoding rate of the convolutional encoder 301 or the convolutional encoder 203 is changed and encoding is achieved, encoded data is decoded by one set of decoding apparatus.

In the foregoing description, a case in which the encoding rate for an outer code is 2/3 and the encoding rate for an inner code is 1 (= 3/3) has been taken as an example. The present techniques can be applied to a case in which the encoding rate for an outer code is set to 2/4 and the encoding rate for an inner code is set to 4/3 (so that the entire encoding rate is 1 or more) to make the encoding rate of the entire encoding apparatus to b/(b + 1) (= 2/3).

Even when a plurality of interleavers 202 and a plurality of convolutional encoders 203 are provided for the encoding apparatus 200 shown in Fig. 13, if the encoding rate of at least one convolutional encoder is set to 1 or more among the convolutional encoder 201 and the plurality of convolutional encoders 203, the present invention can be applied. In addition, the present invention can also be applied to a case in which a plurality of convolutional encoders 203 provided have different encoding rates to each other.

In the foregoing description, a case in which encoded data is mapped on a transfer symbol of the 8PSK modulation method has been taken as an example. The present invention can be applied to cases in which other multi-level modulations are used, such as a case in which the encoding rate of the entire encoding apparatus is set to 3/4 and data is mapped on a transfer symbol of the 16QAM modulation method.

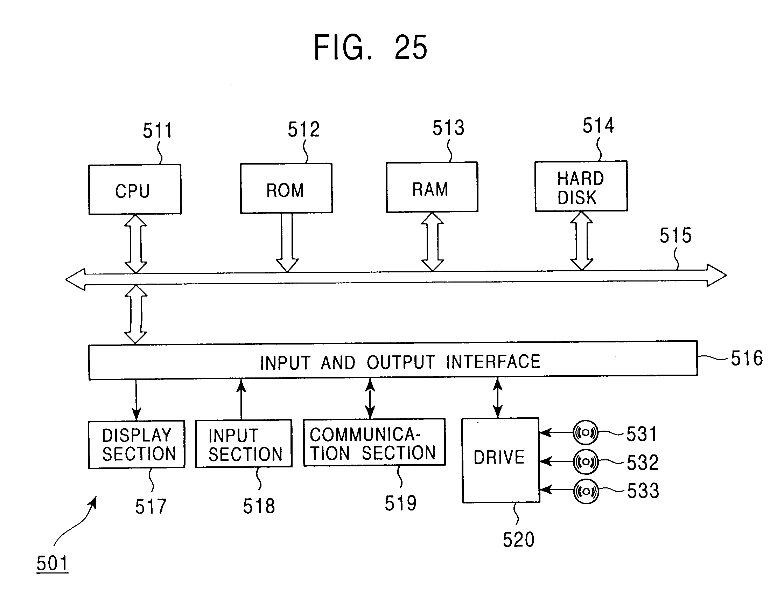

The above-described series of processing can be implemented not only by hardware but also by software. An encoding apparatus which implements the series of processing by software will be described below by referring to Fig. 25.

An encoding apparatus 501 shown in Fig. 25 is formed, for example, of a computer. A CPU (central processing unit) 511 is connected to an input and output interface 516 through a bus 515. When the user inputs an instruction from an input section 518 formed of a keyboard and a mouse, through the input and output interface 516, the CPU 511 loads a program stored in a providing medium, such as a ROM (read-only memory) 512, a hard disk 514, or a recording medium loaded into a drive 520, including a magnetic disk 531, an optical disk 532, or a magneto-optical disk 533; or transferred from a satellite or a network, received through a communication section 519, and stored in the hard disk 514, to a RAM (random-access memory) 513 and executes it. The CPU 511 further outputs a processing result, for example, through the input and output interface 516 to a display section 517 formed of an LCD (liquid crystal display) and others, as required.

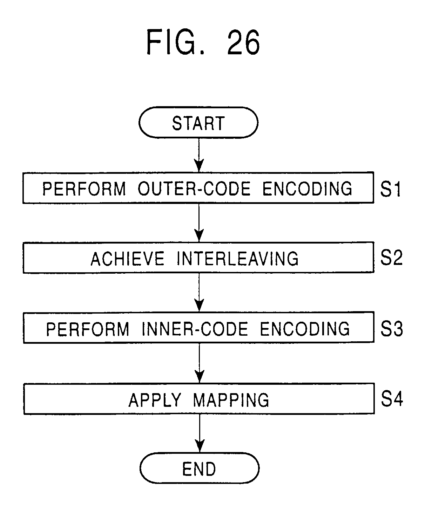

The operation of the CPU 511, which is achieved by loading the program stored in the hard disk 514 into the RAM 513, will be described below by referring to a flowchart shown in Fig. 26. In a step S1, the CPU 511 reads data, for example, received by the communication section 519 and recorded into the hard disk 514, and executes convolutional encoding (outer code) at an encoding rate of 2/3 to transform, for example, two-bit data into a three-bit code. In a step S2, the CPU 511 interleaves the data to which convolutional encoding has been applied in the step S1.

In a step S3, the CPU 511 applies convolutional encoding (inner code) to the data interleaved in the step S2, at an encoding rate of 3/3 to transform, for example, the three-bit data into a three-bit code. In a step S4, the CPU 511 maps the data (for example, the three-bit code) to which convolutional encoding has been applied in the step S3 to one transfer symbol.

In this case, since convolutional encoding is executed (in the step S3) at an encoding rate of 1 (= 3/3) to apply convolutional encoding to input data at an entire encoding rate of 2/3 (= (2/3) x (3/3)), namely, b/(b + 1), a code is mapped on one transfer symbol.

Data mapped in the step S4 is read as is at a predetermined timing or once recorded into the hard disk 514 or another device and then read at a predetermined timing, and transmitted through the communication section 519.

In the present specification, a system refers to an entire gear formed of a plurality of apparatuses.

In so far as the embodiments of the invention described above are implemented, at least in part, using software-controlled data processing apparatus, it will be appreciated that a computer program providing such software control and a storage medium by which such a computer program is stored are envisaged as aspects of the present invention.

## Claims

1. An encoding apparatus comprising:
first transform means for transforming b-bit input data into a (b + 1)-bit outer code;
interleaving means for interleaving the outer code, which has been transformed into by said first transform means;
second transform means for transforming the (b + 1)-bit outer code which has been transformed into by said first transform means and interleaved by said interleaving means, into an inner code having the number of bits equal to (b + 1) or less; and
mapping means for mapping the inner code, which has been transformed into by said second transform means, on one transfer symbol of a predetermined modulation method.

2. An encoding apparatus according to Claim 1,
wherein a predetermined bit is fixed to zero among the b-bit data input to said first transform means, and
a predetermined bit is fixed to zero among the (b + 1)-bit outer code interleaved by said interleaving means, input to said second transform means.

3. An encoding apparatus according to Claim 1,
wherein a predetermined bit is fixed to zero among the (b + 1)-bit outer code which has been transformed into by said first transform means, and
a predetermined bit is fixed to zero among the inner code having the number of bits equal to (b + 1) or less, which has been transformed into by said second transform means.

4. An encoding method comprising:
a first transform step of transforming b-bit input data into a (b + 1)-bit outer code;
an interleaving step of interleaving the outer code, which has been transformed into in said first transform step;
a second transform step of transforming the (b + 1)-bit outer code which has been transformed into in said first transform step and interleaved in said interleaving step, into an inner code having the number of bits equal to (b + 1) or less; and
a mapping step of mapping the inner code, which has been transformed into in said second transform step, on one transfer symbol of a predetermined modulation method.

5. A providing medium for providing a computer-controllable program, the program comprising:
a first transform step of transforming b-bit input data into a (b + 1)-bit outer code;
an interleaving step of interleaving the outer code, which has been transformed into in said first transform step;
a second transform step of transforming the (b + 1)-bit outer code which has been transformed into in said first transform step and interleaved in said interleaving step, into an inner code having the number of bits equal to (b + 1) or less; and
a mapping step of mapping the inner code, which has been transformed into in said second transform step, on one transfer symbol of a predetermined modulation method.

6. A providing medium according to Claim 5, wherein said providing medium is a recording medium into which the program has been recorded.

7. An encoding apparatus comprising:
serial concatenated encoding means which has at least two convolutional encoding sections, including a convolutional encoding section disposed at the top and a convolutional encoding section disposed at the last, and at least one interleaving section disposed between convolutional encoding sections, and in which input data is sequentially input to the convolutional encoding section disposed at the top, to each interleaving section, and then to each convolutional encoding section; and
multi-level modulation means for multi-level-modulating the output of said serial concatenated encoding means,
wherein the encoding rate of at least one convolutional encoding section is 1 or more.

8. An encoding apparatus according to Claim 7, wherein the convolutional encoding section disposed at the top executes convolutional encoding at an encoding rate of less than 1.

9. An encoding method comprising:
a first convolutional-encoding step of convolutional-encoding an input signal at a first encoding rate and of outputting a first convolutional-encoded signal; and
a signal processing step of applying signal processing to the input signal natural-number M times,
wherein each signal processing of the signal processing applied natural-number M times comprises:
an interleaving step of applying interleaving to an input signal; and
a second convolutional-encoding step of convolutional-encoding the processing result obtained in said interleaving step, at a second encoding rate and of outputting a second convolutional-encoded signal;
among the signal processing applied natural-number M times, an input signal input in first signal processing is the first convolutional-encoded signal and input signals input in second and subsequent signal processing are the second convolutional-encoded signal; and
at least one of the first encoding rate and the second encoding rate is 1 or more.

10. An encoding method according to Claim 9, wherein the second encoding rate differs in the signal processing executed natural-number M times.

11. An encoding method according to Claim 9, wherein the first encoding rate is 1 or more.

12. A providing medium for providing a computer-controllable program, the program comprising:
a first convolutional-encoding step of convolutional-encoding an input signal at a first encoding rate and of outputting a first convolutional-encoded signal; and
a signal processing step of applying signal processing to the input signal natural-number M times,
wherein each signal processing of the signal processing applied natural-number M times comprises:
an interleaving step of applying interleaving to an input signal; and
a second convolutional-encoding step of convolutional-encoding the processing result obtained in said interleaving step, at a second encoding rate and of outputting a second convolutional-encoded signal;
among the signal processing executed natural-number M times, an input signal input in first signal processing is the first convolutional-encoded signal and input signals input in second and subsequent signal processing are the second convolutional-encoded signal; and
at least one of the first encoding rate and the second encoding rate is 1 or more.

13. A providing medium according to Claim 12, wherein said providing medium is a recording medium in which the program has been stored.
